# EUROPEAN PATENT APPLICATION

(11) **EP 2 620 531 A1**
(43) Date of publication of application: **31.07.2013**
(21) Application number: 11826703.8
(22) Date of filing: 01.09.2011
(51) Int. Cl.: C30B 23/08, C30B 29/36

(54) **APPARATUS FOR PRODUCING SINGLE CRYSTALS**

(30) Priority: 22.09.2010 JP 2010212339
(71) Applicant: Bridgestone Corporation, Tokyo 104-8340 (JP)
(72) Inventor: KONDO, Daisuke, Kodaira-shi Tokyo 187-8531 (JP)
(74) Representative: Lamb, Martin John Carstairs
(86) International application number: PCT/JP2011/069911
(87) International publication number: WO 2012/039257

(57) **Abstract**

A cover member (40) of an apparatus (1) for producing single crystals is provided with a projection (41) generally in the center. The projection (41) is disposed so as to protrude toward the inside of a crucible main body (30) through a cover member opening (40a). A seed crystal (10) is disposed between a supporting portion (432) and a contact surface (41a) of the projection (41) which is inserted into a guide opening (43h). The apparatus (1) for producing single crystals is configured such that the contact surface (41a) presses the entire back surface of the seed crystal (10), said back surface being on the reverse side of the crystal growth surface of the seed crystal (10), against the projection (41) when a screw thread (41s) that is formed on the projection (41) is screwed to a thread groove (43g) that is formed on an engaging portion (431).

## Description

### TECHNICAL FIELD

The present invention relates to a single crystal manufacturing apparatus employing a modified Rayleigh's method.

### BACKGROUND ART

Conventionally, there is disclosed a method of causing a support portion provided at a capping member to mechanically retain a seed crystal without a need to adhere the seed crystal to the capping member (for example, refer to Patent Literature 1), in a single crystal manufacturing apparatus of obtaining a bulky single crystal by sublimating a sublimation raw material including silicon carbide and then growing a silicon carbide single crystal on a silicon carbide single crystal substrate (referred to as a seed crystal).

In a technique disclosed in Patent Literature 1, a protection member is disposed between a back face of the seed crystal and the capping member, and a gap for temperature control is formed between a back face side of the protection member and the capping member. A growth velocity of a single crystal can be controlled by adjusting intervals of the gap.

### CITATION LIST

### PATENT LITERATURE

Patent Literature 1: Japanese Patent No. 4275308

### SUMMARY OF INVENTION

However, the conventional single crystal manufacturing apparatus described above has entailed the following problem. That is, since a thermal expansion coefficient of a graphite (carbon) crucible is greater than that of a seed crystal (silicon carbide), a gap is produced between a support portion and an outer edge of the seed crystal. Therefore, there will be a concern about entry of a sublimation gas produced when a sublimation raw material sublimates in a space between the back face of the seed crystal provided for temperature control (the back face of the protection member) and the capping member.

In addition, since the seed crystal is not adhered to the support portion, if a gap on the back face side is heterogeneous due to a warp of an error level of the order of some microns to some tens of microns existing in advance in seed crystal, there has been a case in which the quality of the single crystal grown may be heterogeneous. Further, if a diameter of the seed crystal increases, since the seed crystal is likely to warp, cracking of a protection layer on the back face of the seed crystal or lowering of the quality of the single crystal has been likely to significantly occur.

Accordingly, it is an object of the present invention to provide a single crystal manufacturing apparatus that is capable of preventing the damage to a seed crystal or the lowering of quality of the single crystal in a single crystal manufacturing apparatus of such a type that the seed crystal is not to be adhered to the capping member.

To solve the above problem, the present invention has following feature. A feature of the present invention is summarized as a single crystal manufacturing apparatus (single crystal manufacturing apparatus 1) comprising: a crucible main body (crucible main body 30) that having a substantially cylindrical shape in which a bottom portion (bottom portion 30b) is formed at one end portion of the crucible main body and an opening portion (opening portion 30u) is formed at another end of the crucible main body, a sublimation raw material (sublimation raw material 20) being disposed at the bottom portion; and a capping member (capping member 40) that closes the opening portion, on which a seed crystal (seed crystal 10, 11) being disposed at a position facing the sublimation raw material, wherein the single crystal manufacturing apparatus sublimates the sublimation raw material and then recrystallizing a single crystal on the seed crystal, a guide portion (guide portion 43) having a conical face (conical face 43a) is mounted on the capping member, a diameter of the conical face being increased as going down in a growing direction of the single crystal, the capping member has a substantially columnar projection portion (projection portion 41) projecting inward of the crucible main body, a contacting face having a diameter that is equal to a diameter of the seed crystal or greater than the diameter of the seed crystal is formed at the projection portion, the guide portion has: an engagement portion (engagement portion 431) which has an aperture fitting to an outer diameter of the projection portion, and a guide opening portion (guide opening portion 43h) through which the projection portion is inserted; and a support portion (support portion 432) supporting the seed crystal that narrows at least a part of the guide opening portion formed in the engagement portion, a screw thread (screw thread 41s) is formed outside of the projection portion, a screw groove (screw groove 43g) screwed with the screw thread is formed at the engagement portion, the seed crystal is disposed between an end portion of the projection portion inserted through the guide opening portion and the support portion, and the screw thread formed at the projection portion is screwed with the screw groove formed at the engagement portion, whereby the contacting face is formed so as to compress an entire portion of aback face opposite to a crystalline growth face of the seed crystal against the projection portion.

According to the single crystal manufacturing apparatus, the seed crystal is supported by means of the support portion which narrows at least the part of the guide opening portion formed at the engagement portion, and the screw thread formed at the projection portion is screwed with the screw groove formed at the engagement portion, whereby the contacting face is formed so as to compress the entire portion of the back face opposite to the crystal growth face in the seed crystal against the projection portion.

Thus, in the single crystal manufacturing apparatus, since the seed crystal is not to be adhered to the support portion, the seed crystal can be prevented from being damaged due to a difference in stress exerted by a difference in thermal expansion coefficient between a capping member to which the seed crystal is mounted and the seed crystal itself.

In addition, since an outer edge of the seed crystal is compressed against the support portion by means of the contacting face, gapping between the support portion and the outer edge of the seed crystal 10 can be prevented. Further, entry of the sublimation gas as a sublimation raw material between the support portion and the outer edge of the seed crystal can also be prevented.

In the single crystal manufacturing apparatus, the full back face of the seed crystal is compressed against the contacting face, whereby warping of the seed crystal is corrected, cracking of the protection layer of the back face of the seed crystal can be prevented, and a single crystal of its homogenous quality can be produced.

In the above feature of the present invention, a protection member may be disposed between the contacting face and the back face of the seed crystal.

In the above feature of the present invention, the seed crystal may be curved so as to be convex in an opposite direction to the growing direction of the single crystal.

### BRIEF DESCRIPTION OF DRAWINGS

[Fig. 1] Fig. 1 is a sectional view illustrating an outline of a single crystal manufacturing apparatus according to an embodiment of the present invention.
[Fig. 2] Fig. 2 is a sectional view illustrating a single crystal grown in the single crystal manufacturing apparatus according to the embodiment of the present invention.
[Fig. 3] Fig. 3 (a) is a dissembled view showing a guide portion, a seed crystal, and a protection member in a dissembled manner in a capping member of the single crystal manufacturing apparatus, and Fig. 3 (b) is an assembled view of the guide portion, the seed crystal, and the protection member that are assembled in the capping member of the single crystal manufacturing apparatus.
[Fig. 4] Fig. 4 (a) is a dissembled view when another seed crystal is applied to the single crystal manufacturing apparatus, and Fig. 4 (b) is a view illustrating a modification example of the seed crystal.

### DESCRIPTION OF EMBODIMENTS

An embodiment of a single crystal manufacturing apparatus according to the embodiments of the present invention will be described with reference to the drawings. Specifically, a description will be given with respect to (1) Description of Configuration of Single Crystal Manufacturing apparatus, (2) Description of Configuration of Capping Member, (3) Functions/Advantageous Effects, (4) Modification Example of Seed Crystal, and (5) Other Embodiments.

In the following description of the drawings, same or like constituent elements are designated by same or like reference numerals. However, it is to be noted that the drawings are merely schematic, and ratios of the respective dimensions or the like are different from actual ones. Therefore, specific dimensions or the like should be determined in consideration of the following description. In addition, in amongst the drawings as well, the constituent elements in which dimensional interrelationships or ratios are different from each other are included.

### (1) Description of Configuration of Single Crystal Manufacturing apparatus

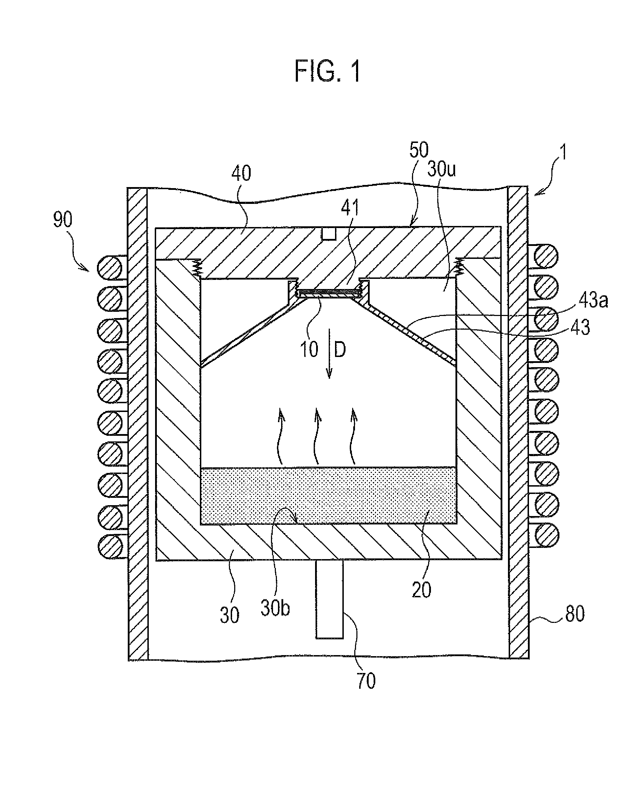

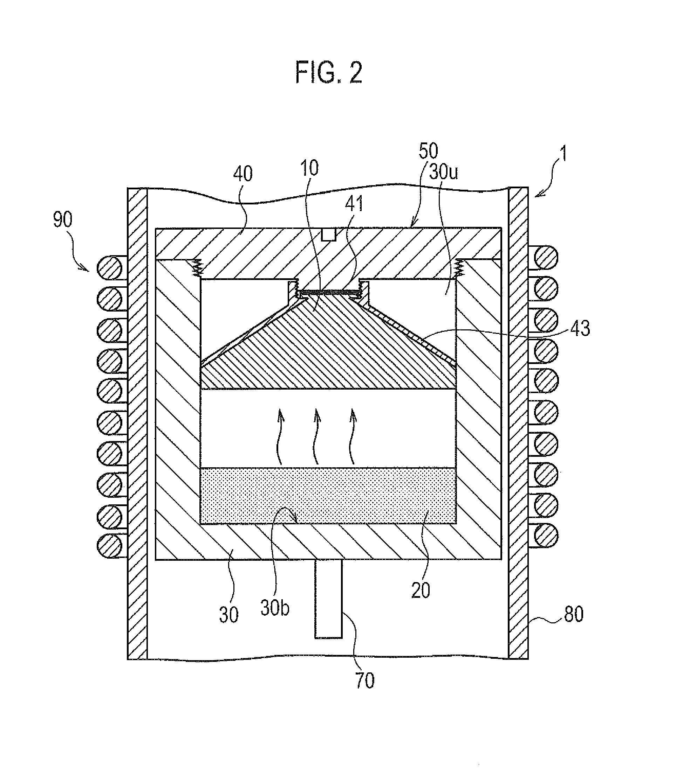

A configuration of the single crystal manufacturing apparatus of producing a silicon carbide single crystal, which is shown as an embodiment, will be described with reference to Fig. 1 and Fig. 2. Fig. 1 is a sectional view illustrating an outline of the single crystal manufacturing apparatus 1. Fig. 2 is a sectional view illustrating a state in which a single crystal is grown by means of the single crystal manufacturing apparatus 1 according to the embodiment of the present invention.

As shown in Fig. 1 and Fig. 2, the single crystal manufacturing apparatus 1 is an apparatus applying the modified Rayleigh's method of sublimating a sublimation raw material 20 and then recrystallizing a single crystal on a seed crystal 10 inside of a graphite crucible 50 in which the sublimation raw material 20 is disposed.

The crucible 50 has a crucible main body 30 and a capping member 40 where the seed crystal 10 is to be disposed. The crucible main body 30 has a substantially cylindrical shape in which a bottom portion 30b is formed at one end portion and an opening portion 30u is formed at another end portion. The sublimation raw material 20 is disposed at the bottom portion 30b. The capping member 40 closes the opening portion 30u, and the seed crystal 10 is disposed at an opposite position to the sublimation raw material 20.

The capping member 40 has a projection portion 41. A guide portion 43 having a conical face 43a is mounted on the capping member 40, and a diameter of conical face 43a increases as going down in a growing direction D of a silicon carbide single crystal is mounted.

The crucible 50 is covered with a heat insulation member (not shown). In addition, the crucible 50 is fixed to the inside of a quartz tube 80 via the support rod 70. At an outer circumference of the quartz tube 80, a heating coil 90 to heat the crucible 50 is provided.

In the embodiment, the diameter of the seed crystal 10 is 76.2 mm, and the thickness is 500 microns.

### (2) Description of Configuration of Capping Member

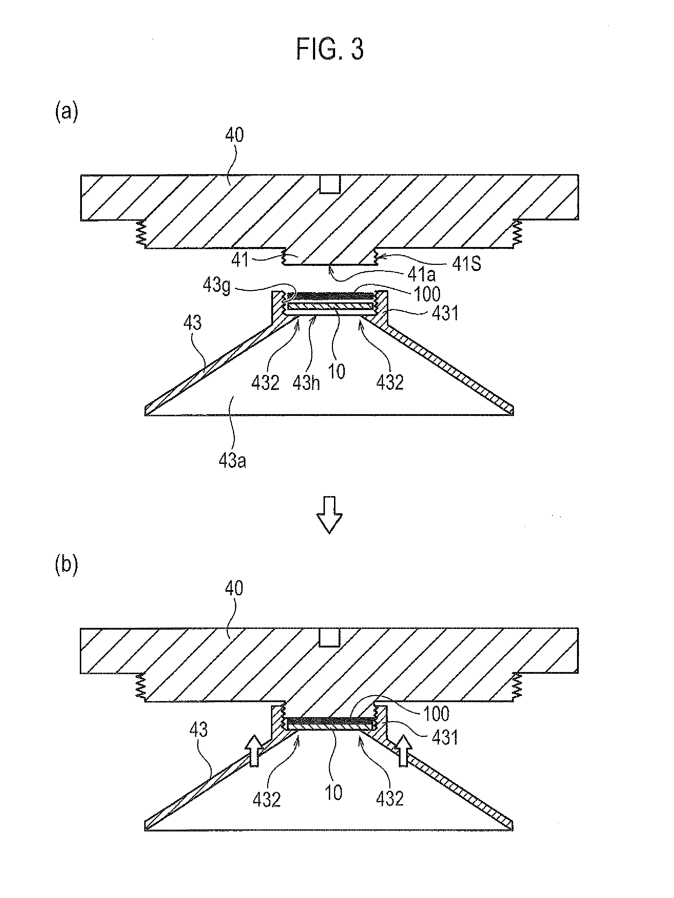

Fig. 3 (a) is a dissembled view showing the capping member 40, the guide portion 43, the seed crystal 10, and a protection member 100 of the single crystal manufacturing apparatus 1 in a dissembled manner, and Fig. 3 (b) is an assembled view in which the capping member 40, the guide portion 43, the seed crystal 10, and the protection member 100 of the single crystal manufacturing apparatus 1 are assembled.

The projection portion 41 is provided at a substantial center part of the capping member 40. The projection portion 41 is formed in a substantially columnar shape in which a contacting face 41a having a diameter that is equal to a diameter of the seed crystal 10 or greater than the diameter of the seed crystal 10 is formed.

The projection portion 41 of the capping member 40 is disposed so as to project inside of the crucible main body 30 via the capping member opening portion 40a. A screw thread 41s is formed outside of the projection portion 41.

The guide portion 43 has an engagement portion 431 to engage with the projection portion 41 and a support portion 432 to support the seed crystal 10. At the engagement portion 431, a guide opening portion 43h having a diameter fitting to an outer diameter of the projection portion 41 is formed. At the guide opening portion 43h of the engagement portion 431, a screw groove 43g to be screwed with the screw thread 41s is formed. The projection portion 41 is inserted through the guide opening portion 43h. The support portion 432 is formed to narrow at least a part of the guide opening portion 43h formed at the engagement portion 431.

In the embodiment, the support portion 432 is formed in a peaked shape in which an edge of the guide opening portion 43h extends to an opening center of the opening portion. The support portion 432 is an aperture that is smaller than an aperture of the guide opening portion 43h, and forms an opening having a diameter that is smaller than the diameter of the seed crystal 10.

The seed crystal 10 is disposed between the contacting face 41a of the projection portion 41 inserted through the guide opening portion 43h and the support portion 432. The seed crystal 10 is inserted from a top side of the guide opening portion 43h, whereby the seed crystal is supported by means of the support portion 432.

The screw thread 41s formed at the projection portion 41 is screwed with the screw groove 43g formed at the engagement portion 431, whereby the contacting face 41a is formed so as to compress the entire portion of the back face opposite to the crystalline growth face in the seed crystal 10 against the proj ection portion 41.

In the embodiment, the protection member 100 is disposed between the contacting face 41a and the back face of the seed crystal 10, and the contacting face 41a is formed so as to compress the full back face of the seed crystal 10 via the protection member 100. The protection member 100 is a carbon fiber, for example. It is preferable that the protection member 100 be made of a material having its flexibility.

### (3) Functions/Advantageous Effects

According to the single crystal manufacturing apparatus 1, the seed crystal 10 is supported by means of the support portion 432 formed after at least a part of the guide opening portion 43h formed at the engagement portion 431 has been narrowed, and the screw thread 41s formed at the projection portion 41 is screwed with the screw groove 43g formed at the engagement portion 431, whereby the contacting face 41a is formed so as to compress the entire portion of the back face opposite to the crystalline growth face in the seed crystal 10 against the projection portion 41.

In the single crystal manufacturing apparatus 1, since the seed crystal 10 is not adhered to the support portion 432, the seed crystal can be prevented from being damaged due to a difference in stress exerted by a difference in thermal expansion coefficient between the capping member to which the seed crystal is mounted and the seed crystal itself.

In addition, in the single crystal manufacturing apparatus 1, the seed crystal 10 is not adhered to the support portion 432. The full back face of the seed crystal 10 is compressed against the contacting face 41a, whereby the outer edge of the seed crystal 10 is compressed against the support portion 432 by means of the contacting face 41a. Thus, gapping between the support portion 432 and the outer edge of the seed crystal 10 can be prevented. In this manner, entry of the sublimation gas as a sublimation raw material between the support portion 432 and the outer edge of the seed crystal 10 can be prevented.

Further, in the single crystal manufacturing apparatus 1, the full back face of the seed crystal 10 is compressed against the contacting face 41a, whereby warping of the seed crystal 10 is corrected. Cracking of the protection layer on the back face of the seed crystal 10 can be prevented, and a single crystal of its homogenous quality can be produced.

Furthermore, in the embodiment, the protection member 100 is disposed between the contacting face 41a and the back face of the seed crystal 10. The contacting face 41a is formed so as to compress the full back face of the seed crystal 10 via the protection member 100 made of a carbon fiber.

In this manner, by interposing the carbon fiber, a gap between a part of the capping member 40 and the seed crystal 10 can be reduced more reliably, and macroscopic defects can be prevented.

### (4) Modification Example of Seed Crystal

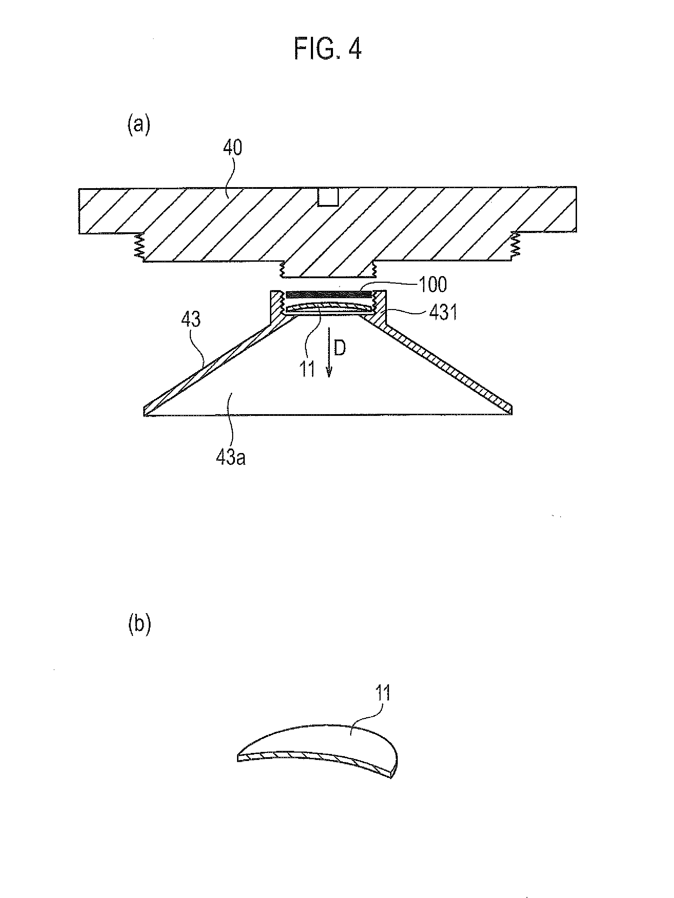

Fig. 4 (a) is a dissembled view when another seed crystal 11 is applied to the single crystal manufacturing apparatus 1, and Fig. 4 (b) is a view illustrating the seed crystal 11 for use in the single crystal manufacturing apparatus 1. The seed crystal 11 is curved so as to be convex in an opposite direction to the growing direction D of the single crystal.

In the embodiment, the diameter of the seed crystal 11 is 76. 2 mm, and its thickness is 500 microns. Its warping is of the order of 30 microns.

The thus curved seed crystal 11 is compressed against the contacting face 41a of the projection portion 41, whereby a curved face protruded in the opposite direction to the growing direction is flattened. In addition, by means of compression, curving in the growing direction side can be prevented, and the growth face in the seed crystal 11 can be retained so as to be flat. Therefore, cracking of the protection layer on the back face of the seed crystal 11 can be prevented, and a single crystal of its homogenous quality can be produced.

### (5) Other Embodiments

As described above, while the contents of the present invention were disclosed through the embodiment of the present invention, it is not to be understood that the discussion and drawings forming part of this disclosure limit the present invention. From this disclosure, a variety of alternate embodiments or examples would be self-evident to one skilled in the art. For example, the embodiment of the present invention can be altered as follows.

The embodiment described that the protection member 100 was disposed between the contacting face 41a and the back face of the seed crystal 10. However, the protection member 100 does not always need to be disposed.

In a case where the protection member 100 is not provided, it is preferable to apply a refinement treatment to a surface of the capping member 40 abutting against the seed crystal 10 to thereby achieve a refined structure. By refining the surface, even if a slight gap still remains between the seed crystal 10 and the capping member 40 (contacting face 41a), generation of macroscopic defects can be prevented.

Thus, it is a matter of course that the present invention includes a variety of embodiments or the like that are not described herein. Therefore, the technical scope of the present invention is defined only by the specified matters of the invention related to the claims reasonable from the foregoing description.

All the contents of Japanese Patent Application No. 2010-212339 (filed on September 22, 2010) are incorporated in the present specification by way of reference.

According to the present invention, in the single crystal manufacturing apparatus of such a type that a seed crystal is not adhered to a capping member, the damage to the seed crystal or the lowering of the quality of the single crystal can be prevented.

## Claims

1. A single crystal manufacturing apparatus comprising:
a crucible main body that having a substantially cylindrical shape in which a bottom portion is formed at one end portion of the crucible main body and an opening portion is formed at another end of the crucible main body, a sublimation raw material being disposed at the bottom portion; and
a capping member that closes the opening portion, on which a seed crystal being disposed at a position facing the sublimation raw material, wherein
the single crystal manufacturing apparatus sublimates the sublimation raw material and then recrystallizing a single crystal on the seed crystal,
a guide portion having a conical face is mounted on the capping member, a diameter of the conical face being increased as going down in a growing direction of the single crystal,
the capping member has a substantially columnar projection portion projecting inward of the crucible main body,
a contacting face having a diameter that is equal to a diameter of the seed crystal or greater than the diameter of the seed crystal is formed at the proj ection portion,
the guide portion has:
an engagement portion which has an aperture fitting to an outer diameter of the projection portion, and a guide opening portion through which the projection portion is inserted; and
a support portion supporting the seed crystal that narrows at least a part of the guide opening portion formed in the engagement portion,
a screw thread is formed outside of the projection portion,
a screw groove screwed with the screw thread is formed at the engagement portion,
the seed crystal is disposed between an end portion of the projection portion inserted through the guide opening portion and the support portion, and
the screw thread formed at the projection portion is screwed with the screw groove formed at the engagement portion, whereby the contacting face is formed so as to compress an entire portion of aback face opposite to a crystalline growth face of the seed crystal against the projection portion.

2. The single crystal manufacturing apparatus according to claim 1, wherein a protection member is disposed between the contacting face and the back face of the seed crystal.

3. The single crystal manufacturing apparatus according to claim 1 or 2, wherein the seed crystal is curved so as to be convex in an opposite direction to the growing direction of the single crystal.
